# EUROPEAN PATENT APPLICATION

(11) **EP 2 166 537 A1**
(43) Date of publication of application: **24.03.2010**
(21) Application number: 09169809.2
(22) Date of filing: 09.09.2009
(51) Int. Cl.: G11B 20/10

(54) **Apparatus and method of generating reference level of viterbi decoder**

(30) Priority: 11.09.2008 KR 20080090006
(71) Applicant: SAMSUNG ELECTRONICS CO., LTD., Suwon-si Gyeonggi-do 442-742 (KR)
(72) Inventor: Zhao, Hui, Gyeonggi-do (KR); Park, Hyun-soo, Seoul (KR)
(74) Representative: Clark, David James

(57) **Abstract**

An apparatus (115, 215) of generating the optimum reference level of a Viterbi decoder (110, 210) for an input signal includes: a first reference level detection unit (120, 220) detecting a first reference level using a delayed input signal from the Viterbi decoder (110, 210) and an output signal of the Viterbi decoder (110, 210); a second reference level detection unit (130, 230) detecting a second reference level using input signals input after and before one clock cycle with respect to the delayed input signal and the output signal; and a control unit (140, 240) controlling one of the first reference level and the second reference level to be set as the reference level of the Viterbi decoder by using a result of comparison between a first square level error for the first reference level calculated in the first reference level detection unit (120, 220) and a second square level error for the second reference level calculated in the second reference level detection unit (130, 230).

## Description

### BACKGROUND OF THE INVENTION

Aspects of the invention relate to a Viterbi decoder, and more particularly, to an apparatus and method of generating an reference level of a Viterbi decoder.

A Viterbi decoder is used to detect a binary signal from an input signal. For example, the Viterbi decoder is used in an optical disk drive to convert a radio frequency (RF) signal read from a disc into a digital signal. The Viterbi decoder detects the binary signal using a difference between the input signal and the reference level of the Viterbi decoder. Thus, in order to ensure high efficiency, the Viterbi decoder uses an optimum reference level for a condition for generating the input signal. If the optimum reference level is not used for the condition for generating the input signal, errors may be included in the binary signal output from the Viterbi decoder.

### SUMMARY OF THE INVENTION

Aspects of the invention provide an apparatus and method of adaptably generating an optimum reference level of a Viterbi decoder for an input signal.

According to an aspect of the invention, there is provided an apparatus for generating a reference level of a Viterbi decoder, the Viterbi decoder receiving an input signal and outputting an output signal according to the reference level, the apparatus comprising: a first reference level detection unit to detect a first reference level using a first delayed input signal and the output signal of the Viterbi decoder, the delayed input signal being delayed relative to the input signal; a second reference level detection unit to detect second reference levels using the output signal of the Viterbi decoder and a second delayed input signal and a third delayed input signal input one clock cycle after and before the first delayed input signal ; and a control unit to select one of the first reference level and the second reference level as the reference level of the Viterbi decoder using a result of a comparison between a first square level error for the first reference level calculated in the first reference level detection unit and a second square level errors for the second reference levels calculated in the second reference level detection unit.

Suitably, the first reference level detection unit obtains the first square level error by squaring a difference between the first reference level and the input signal of the Viterbi decoder, and the second level detection unit obtains the second square level errors by squaring the differences between each of the second reference levels and the input signal of the Viterbi decoder, wherein the control unit selects the reference level to be the one of the first and second reference levels having a smallest of the first and second square level errors.

Suitably, the second reference level detection unit comprises: a first reference level detector to detect one of the second reference levels using the second delayed input signal input one clock cycle after the first delayed input signal; and a second reference level detector to detect the other one of the second reference levels using the third delayed input signal input one clock cycle before the first delayed input signal, and the control unit selects as the reference level the one of the first and second reference levels having the smallest of the first and the second square level errors respectively calculated in the first reference level detection unit and the second reference level detection unit .

Suitably, the first reference level detection unit, the first reference level detector, and the second reference level detector respectively each comprise: a delaying unit to delay the input signal of the Viterbi decoder; a buffer to store the output signal of the Viterbi decoder by a predetermined bit and to output the stored signal; a multiplexer selectively transmits the delayed input signal output from the delaying unit according to the output stored signal output from the buffer; an average value detector group comprising a plurality of average value detectors which detects an average value of the selectively transmitted signal through the multiplexer and to output the detected value, the number of the average value detectors corresponding to a number of reference levels, which can be generated; a memory to store at least one of the reference values output from the average value detector group; and a square level error calculator to calculate the square level error using the one of the reference levels stored in the memory and the input signal of the Viterbi decoder, the delaying unit included in the first reference level detector outputs a signal input one clock cycle after the input signal output from the delaying unit included in the first reference level detection unit, and the delaying unit included in the second reference level detector outputs a signal input one clock cycle before after the input signal output from the delaying unit included in the first reference level detection unit, wherein the square level error calculator uses an ideal reference level from among the reference levels stored in the memory.

According to an aspect of the invention, there is provided a method of generating a reference level of a Viterbi decoder, the Viterbi decoder receiving an input signal and outputting an output signal according to the reference level, the method comprising: receiving the input signal and the output signal from the Viterbi decoder; detecting a first reference level of the Viterbi decoder using a first delayed input signal and the received output signal; detecting second reference levels using the output signal from the Viterbi decoder and a second delayed input signal and a third delayed input signal input one clock cycle after and before the first delayed input signal; respectively calculating a first square level error for the first reference level and second square level errors for the second reference levels; and selecting as the reference level for the Viterbi decoder according to a result of a comparison between the calculated first square level error and the second square level errors, wherein the calculating the first square level error comprises squaring a difference between the detected first reference level and the input signal of the Viterbi decoder, and the calculating the second square level error comprises squaring corresponding differences between the second reference levels and the input signal of the Viterbi decoder.

Suitably, the selecting as the reference level comprises selecting as the reference level the one of the first and second reference levels corresponding to a smallest one of the first and the second square level errors.

Suitably, the detecting of the second reference levels comprises: detecting one of the second reference levels using the second delayed input signal input one clock cycle after the first delayed input signal; and detecting the other one of the second reference levels using the third delayed input signal input one clock cycle before the first delayed input signal, the second square level errors for the second reference levels comprise a square level error for the second delayed input signal and a square level error for the third delayed input signal, and the selecting of the reference level of the Viterbi decoder comprises selecting as the reference level the one of the first and second reference levels corresponding to the smallest one of the first square level error and the second square level errors.

According an aspect of the invention, there is provided an apparatus for generating a reference level of a Viterbi decoder which converts an input signal to an output signal using the reference level, the apparatus comprising: a first reference level detection unit to detect a first reference level using a first input signal and the output signal of the Viterbi decoder, and to calculate a first error using the detected first reference level and the input signal of the Viterbi decoder; a second reference level detection unit to detect a second reference level other than the first reference level using a second input signal and the output signal, and to calculate a second error using the detected second reference level and the input signal of the Viterbi decoder, the second input signal being temporally different from the first input signal; and a control unit to select the first reference level to be the reference level used by the Viterbi decoder where the calculated second error is more than the calculated first error, and to select the second reference level to be the reference level used by the Viterbi decoder where the calculated second error is not more than the calculated first error.

According an aspect of the invention, there is provided a method of generating a reference level of a Viterbi decoder which converts an input signal to an output signal using the reference level, the method comprising: detecting a first reference level using a first input signal and the output signal of the Viterbi decoder; calculating a first error using the detected first reference level and the input signal of the Viterbi decoder; detecting a second reference level other than the first reference level using a second input signal and the output signal, the second input signal being temporally different from the first input signal; calculating a second error using the detected second reference level and the input signal of the Viterbi decoder; selecting the first reference level to be the reference level used by the Viterbi decoder where the calculated second error is more than the calculated first error; and selecting the second reference level to be the reference level used by the Viterbi decoder where the calculated second error is not more than the calculated first error.

According to the present invention there is provided an apparatus and method as set forth in the appended claims. Other features of the invention will be apparent from the dependent claims, and the description which follows.

### BRIEF DESCRIPTION OF THE DRAWINGS

For a better understanding of the invention, and to show how embodiments of the same may be carried into effect, reference will now be made, by way of example, to the accompanying diagrammatic drawings in which:
FIG. 1 is a block diagram of a device including an apparatus for generating a reference level of a Viterbi decoder according to an embodiment of the present invention;
FIG. 2 is a block diagram of a device including an apparatus for generating a reference level of a Viterbi decoder according to another embodiment of the present invention;
FIG. 3 is a flowchart illustrating a method of generating a reference level of a Viterbi decoder according to an embodiment of the present invention; and
FIG. 4 is a flowchart illustrating a method of generating a reference level of a Viterbi decoder according to another embodiment of the present invention.

### DETAILED DESCRIPTION OF THE EMBODIMENTS

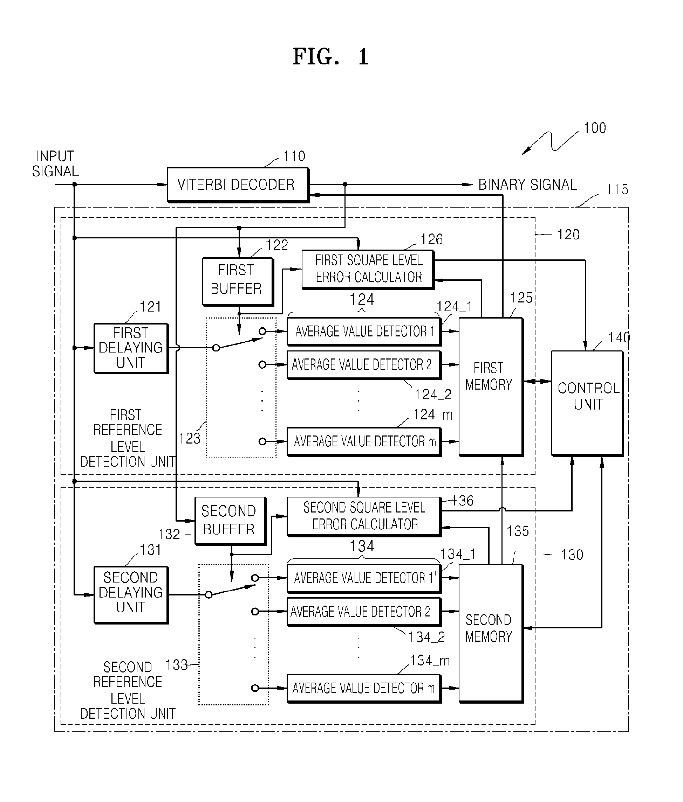

FIG. 1 is a block diagram of a device 100 including an apparatus 115 for generating a reference level of a Viterbi decoder 110 according to an embodiment of the present invention. The device 100 may be described as an adaptable Viterbi decoder. While not required in all aspects, the decoder 110 and the apparatus 115 may comprise one or more processors and/or processing elements of an integrated circuit and can be implemented using software and/or firmware.

The Viterbi decoder 110 outputs a binary signal of an input signal using a difference between the input signal and the reference level provided from the apparatus 115 for generating a reference level. For example, the Viterbi decoder 110 may be configured to generate a state metric (or a path metric) by obtaining the difference between the input signal and the reference level using a branch metric generator (not illustrated). If the device 100 is applied to an optical disc drive, the input signal may be defined as a radio frequency (RF) signal, such as that obtained from an optical pickup reading an optical recording medium.

The apparatus 115 includes a first reference level detection unit 120, a second reference level detection unit 130, and a control unit 140. The first reference level detection unit 120 detects a first reference level of the Viterbi decoder 110 using a delayed signal for the input signal of the Viterbi decoder 110 and an output signal of the Viterbi decoder 110. Accordingly, the first reference level detection unit 120 includes a first delaying unit 121, a first buffer 122, a first multiplexer 123, a first average value detector group 124, a first memory 125, and a first square level error calculator 126.

When an input signal is received, the first delaying unit 121 outputs a first delayed input signal. The first delayed input signal is the input signal delayed by at least one clock period. While not limited thereto, the clock period corresponds to the number of a pass memory (not illustrated) of an X-axis included in the Viterbi decoder 110. Thus, a delaying period of the first delaying unit 121 may be defined to have a period proportional to the number of taps of the Viterbi decoder 110.

The first buffer 122 stores an output signal of the Viterbi decoder 110 by a predetermined bit, and outputs the stored signal. For example, when the reference level output from the apparatus 115 is the reference level adaptable for a partial response (PR) level 1, 2, 1, the first buffer 122 may store the output signal of the Viterbi decoder 110 by a three-bit and output the stored signal. The first buffer 122 may be formed of a First In First Out (FIFO) buffer, but need not in all aspects of the invention.

The first multiplexer 123 selectively transmits the first delayed input signal output from the first delaying unit 121 according to the signal output from the first buffer 122. For example, when the signal output from the first buffer 122 is "000," the first multiplexer 123 transmits the first delayed input signal output from the first delaying unit 121 to a first average value detector 124_1. When the signal output from the first buffer 122 is "111," the first multiplexer 123 transmits the first delayed input signal output from the first delaying unit 121 to an m^{th} average value detector 124_m. When the signal output from the first buffer 122 is three bits as described above, m becomes 8, since the number of the first through m^{th} average value detectors 124_1 through 124_m correspond to the number of the reference level, which may be generated.

The first through m^{th} average value detectors 124_1 through 124_m detect average values of the signal transmitted from the first multiplexer 123. While not required in all aspects, the first through m^{th} average value detectors 124_1 through 124_m may be configured to obtain an average value for a signal input during a predetermined time period or to obtain an average value for a signal input using a low pass filter.

The first memory 125 stores the average values respectively output from the first through m^{th} average value detectors 124_1 through 124_m. Thus, while not required in all aspects, the first memory 125 may store at least a value and the stored value may be defined as a reference level value adaptable to the input signal.

The first square level error calculator 126 calculates square level errors using the input signal of the Viterbi decoder 110 and the reference level values read from first memory 125. The reference level value read from the first memory 125 is an ideal reference level value from among the reference level values stored in the first memory 125. Accordingly, while not required in all aspects, the first square level error calculator 126 further performs a function for detecting the ideal reference level value from among the reference level values read from the first memory 125. That is, as shown, the value output from the first buffer 122 may be used to identify one of the plurality of reference level values read from the first memory 125 as the ideal reference level value. The ideal reference level value is the value for minimizing an error of the binary signal output from the Viterbi decoder 110.

The function for detecting the one ideal reference level value from the plurality of reference level values read from the first memory 125 may be separated from the first square level error calculator 126 in another embodiment. That is, the first square level error calculator 126 may be realized to perform only a square level operation function, and an element for detecting the one ideal reference level value may be disposed between the first square level error calculator 126 and the first memory 125.

The first square level error calculator 126 may obtain a square level error by squaring the difference between the input signal and the ideal reference level value read from the first memory 125, as shown in Equation 1 below.

### Equation 1

### Square level error = (input signal - reference level)²

In Equation 1, the reference level is the ideal reference level value from the reference level values read from the first memory 125. The first square level error calculator 126 provides the obtained square level error to the control unit 140.

The second reference level detection unit 130 includes a second delaying unit 131, a second buffer 132, a second multiplexer 133, a second average value detector group 134, a second memory 135, and a second square level error calculator 136, as illustrated in FIG. 1. The second reference level detection unit 130 detects the reference level for a signal input after one clock cycle with respect to the first delayed input signal output from the first delaying unit 121 and then, detects the reference level for a signal input before one clock cycle with respect to the first delayed input signal output from the first delaying unit 121. For example, if the first delayed input signal output from the first delaying unit 121 is the input signal delayed by 10 clock periods (or 10 clock cycles), the second reference level detection unit 130 detects the reference level for the input signal delayed by 11 clock periods and then, detects the reference level for the input signal delayed by 9 clock periods.

Specifically, when the input signal is received, the second delaying unit 131 firstly outputs a second delayed input signal delayed by a clock period next to the first delayed input signal output from the first delaying unit 121. For example, when the first delayed input signal corresponds to the PR level 1, 2, 1, the second delayed input signal output from the second delaying unit 131 may correspond to the PR level X, 1, 2. Here, X is an unknown value.

The second buffer 132 stores the output signal of the Viterbi decoder 110 by a predetermined bit and outputs the stored signal, as in the first buffer 122. The second multiplexer 133 selectively transmits the second delayed input signal output from the second delaying unit 131 according to the signal output from the second buffer 132, as in the first multiplexer 123. The second average value detector group 134 detects the average value for the input signal and stores the detected value in the second memory 135, as in the first average value detector group 124. Accordingly, while not required in all aspects, the shown second memory 135 stores the reference level value of the input signal delayed by one clock period next to the input signal for the reference level values stored in the first memory 125. The reference level value stored in the second memory 135 may also be defined as the reference level value adaptable for the input signal. The second memory 135 may store at least one reference level value.

The second square level error calculator 136 calculates an ideal reference level value from the input signal of the Viterbi decoder 110 and the reference level values stored in the second memory 135 as in Equation 1 so as to obtain a square level error and provides the obtained square level error to the control unit 140. Accordingly, while not required in all aspects, the second square level error calculator 136 performs a function for detecting the ideal reference level value from the reference level values stored in the second memory 135 by the output signal of the second buffer 132, as in the first square level error calculator 126. In another embodiment, the second square level error calculator 136 may be realized to perform only a square level operation function and an element for detecting the ideal reference level value may be disposed between the second square level error calculator 136 and the second memory 135, as in the first square level error calculator 126.

The control unit 140 compares the first square level error transmitted from the first reference level detection unit 120 and the second square level error transmitted from the second reference level detection unit 130. As a result, if the first square level error is smaller than the second square level error, the reference level values stored in the first memory 125 and the second memory 135 are maintained.

However, if the first square level error is not smaller than the second square level error, the control unit 140 replaces the reference level value stored in the first memory 125 with the reference level value stored in the second memory 135. That is, the reference level value stored in the first memory 125 is updated to the reference level value stored in the second memory 135.

Then, the second reference level detection unit 130 detects the reference level for the signal input before one clock period with respect to the first delayed input signal output from the first delaying unit 121. That is, when the input signal is received, the second delaying unit 131 firstly outputs a third delayed input signal that is an input signal input one clock cycle prior to the first delayed input signal output from the first delaying unit 121 (i.e., one that is not delayed by one clock cycle as in the first delayed input signal). For example, when the first delayed input signal corresponds to the PR level 1, 2, 1, the third delayed input signal output from the second delaying unit 131 may correspond to the PR level 1, 2, X. Here, X is an unknown value.

The second buffer 132 stores the output signal of the Viterbi decoder 110 by a predetermined bit and outputs the stored signal, as in the first buffer 122. The second multiplexer 133 selectively transmits the third delayed input signal output from the second delaying unit 131 according to the signal output from the second buffer 132, as in the first multiplexer 123. The second average value detector group 134 detects the average value for the input signal and stores the detected value in the second memory 135, as in the first average value detector group 124. Accordingly, the second memory 135 may be updated to the reference level value of the third delayed input signal, which corresponds to the input signal input one clock cycle before the input signal used to generate the reference level values stored in the first memory 125.

When the reference level stored in the first memory 125 is updated to the reference level value of the second delayed input signal input after one clock cycle that is previously stored in the second memory 135, the reference level value currently stored in the second memory 135 becomes the reference level of the third delayed input signal input more than two clock cycles prior to the second delayed input signals used to obtain the reference level values currently stored in the first memory 125.

The second square level error calculator 136 calculates the ideal reference level detected from the input signal of the Viterbi decoder 110 and the reference level currently stored in the second memory 135 as in Equation 1 so as to obtain a square level error and provides the obtained square level error to the control unit 140.

The control unit 140 again compares the first error square level error transmitted from the first reference level detection unit 120 and the second square level error transmitted from the second reference level detection unit 130. As a result, if the first square level error is smaller than the second square level error, the control unit 140 controls the first memory 125 so as to generate the reference level value stored in the first memory 125 as the reference level value of the Viterbi decoder 110. Accordingly, the first memory 125 transmits the stored reference level value to the Viterbi decoder 110.

However, as a result, if the first square level error is not smaller than the second square level error, the control unit 140 replaces the reference level value stored in the first memory 125 with the reference level value stored in the second memory 135. If the reference level stored in the first memory 125 is updated to the reference level value detected for the third delayed input signal input prior to one clock cycle before the first delayed input signal, the first square level error is a value that is calculated again using the updated reference value.

Accordingly, the control unit 140 may control the first reference level detection unit 120 and the second reference level detection unit 130 so as to provide the reference level value having a smallest square level error from among the reference level value detected from the second reference level detection unit 130 using the second delayed input signal input posterior to one clock cycle(+1 clock cycle) with respect to the first delayed input signal, the reference level value detected from the second reference level detection unit 130 using the third delayed input signal input prior to one clock cycle (-1 clock cycle) with respect to the first delayed input signal, and the reference level value detected from the first reference level detection unit 120 using the first delayed input signal, as the reference level of the Viterbi decoder 110. Thus, an optimum reference level adaptable for the input signal is provided to the Viterbi decoder 110 and an error generation rate in the binary signal output from the Viterbi decoder 110 may be reduced.

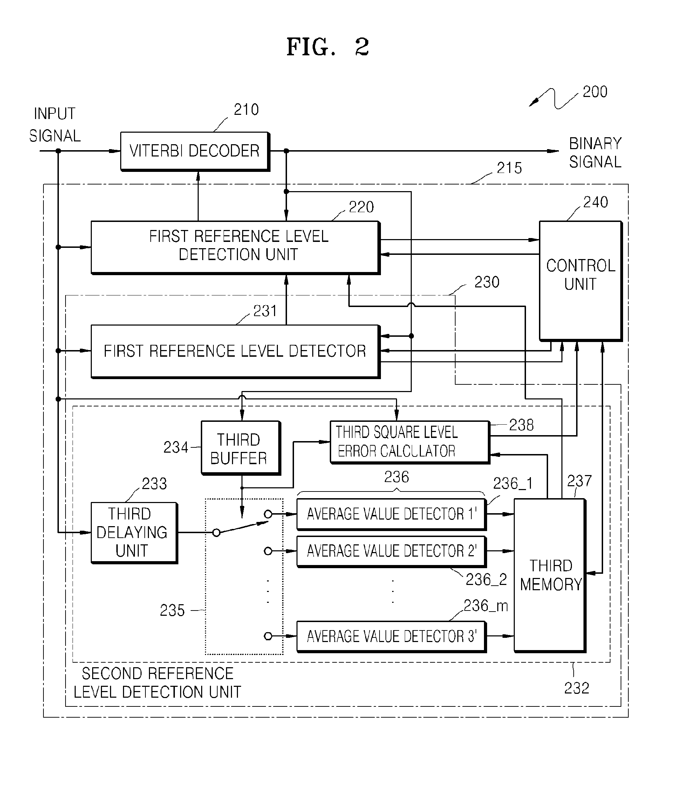

FIG. 2 is a block diagram of a device 200 including an apparatus 215 for generating a reference level of a Viterbi decoder 210 according to an embodiment of the invention. The apparatus 215 includes a first reference level detection unit 220, a second reference level detection unit 230, and a control unit 240. The second reference level detection unit 130 of FIG. 1 detects the reference level for the second delayed input signal input after one clock cycle with respect to the first delayed input signal and the reference level for the third delayed input signal input before one clock cycle with respect to the first delayed input signal after a time lag needed to calculate both sets of values. In contrast, the second reference level detection unit 230 of FIG. 2 separately includes a function block for detecting the reference level for the signal input after one clock cycle with respect to the first delayed input signal of the first reference level detection unit 220 and the reference level for the signal input before one clock cycle with respect to the first delayed input signal of the first reference level detection unit 220. Thus, the second reference level detection unit 230 of FIG. 2 detects both sets of values at the same time. While not required in all aspects, the decoder 210 and the apparatus 215 may comprise one or more processors and/or processing elements of an integrated circuit and can be implemented using software and/or firmware.

In FIG. 2, the reference level for the signal input after one clock cycle with respect to the first delayed input signal and the reference level for the signal input before one clock cycle with respect to the first delayed input signal may be simultaneously detected. Accordingly, the optimum reference level for the input signal may be adaptably provided to the Viterbi decoder 210 more rapidly in FIG. 2 than in FIG. 1.

Therefore, the Viterbi decoder 210 and the first reference level detection unit 220 included in the device 200 of FIG. 2 are the same as the Viterbi decoder 110 and the first reference level detection unit 120 included in the device 100 of FIG. 1. However, unlike the second reference level detection unit 130 of FIG. 1, the second reference level detection unit 230 of FIG. 2 includes first and second reference level detectors 231 and 232.

The first reference level detector 231 and the second reference level detector 232 included in the second reference level detection unit 230 are configured similar to the second reference level detection unit 130 of FIG. 1. For example, the second reference level detection unit 232 of FIG. 2 includes a third delaying unit 233, buffer 234, multiplexer 235, average value detector group 236, memory 237 and square level error calculator 238 coupled as described above in relation to the second error detection unit 130 of FIG. 1. However, a delaying unit (not illustrated) included in the first reference level detector 231 outputs the signal input after one clock cycle with respect to a delay signal from a delaying unit (not illustrated) included in the first reference level detection unit 220, and a third delaying unit 233 included in the second reference level detector 232 outputs the signal input before one clock cycle with respect to the delay signal from the delaying unit (not illustrated) included in the first reference level detection unit 220.

Accordingly, a memory (not illustrated) included in the first reference level detection unit 220 stores the reference level value that is same as the reference level value stored in the first memory 125 of FIG. 1. Also, the reference level value stored in a memory (not illustrated) included in the first reference level detector 231 becomes the reference level value for the signal input after one clock cycle with respect to the reference level value stored in the first reference level detection unit 220. The reference level value stored in a third memory 237 included in the second reference level detection unit 232 becomes the reference level value for the signal input before one clock cycle with respect to the reference level value stored in the first reference level detection unit 220. As such, when each reference level value is detected, the first reference level detection unit 220, the first reference level detector 231, and the second reference level detector 232 calculate the square level errors for an ideal reference level value from among the detected reference level value and provides the calculated square level errors to the control unit 240.

The control unit 240 controls the first reference level detection unit 220, the first reference level detector 231, and the second reference level detector 232 so as to generate the reference level value corresponding to the smallest square level error from among three square level errors as the reference level of the Viterbi decoder 210.

That is, when the square level error provided from the first reference level detection unit 220 is the smallest, the control unit 240 controls the first reference level detection unit 220 so as to provide the reference level value stored in the first reference level detection unit 220 as the reference level of the Viterbi decoder 210. However, when the square level error provided from the first reference level detector 231 is the smallest, the control unit 240 replaces the reference level value stored in the first reference level detection unit 220 with the reference level value stored in the first reference level detector 231 and controls the first reference level detection unit 220 and the first reference level detector 231 so as to provide the replacement reference level value as the reference level of the Viterbi decoder 210. The replacing of the reference level may be performed by updating the reference level value stored in the memory (not shown) included in the first reference level detection unit 220 to the reference level value stored in the memory included in the first reference level detector 231.

When the square level error provided from the second reference level detector 232 is the smallest, the control unit 240 replaces the reference level value stored in the first reference level detection unit 220 with the reference level value stored in the third memory 237 included in the second reference level detector 232 and controls the first reference level detection unit 220 and the second reference level detector 232 so as to provide the replacement reference level value as the reference level of the Viterbi decoder 210. The replacing of the reference level may be performed by updating the reference level value stored in the memory included in the first reference level detection unit 220 to the reference level value stored in the third memory 237. The memories mentioned in FIG. 2 may store at least one reference level value, as in the first and second memories 125 and 135

In FIGS. 1 and 2, when the reference level values stored in the memories of the first reference level detection units 120 and 220 are replaced with the reference level values stored in the memories of other reference level detection units, the reference level values are directly transmitted between the memories that are controlled by the control units 140 and 240, without passing through the control unit 140 and 240. However, the control unit 140 and 240 may read the reference level values stored in the memories of other reference level detection units and may replace or update the reference level values stored in the memories of the first reference level detection units 120 and 220. For example, the control unit 140 may read the reference level value stored in the second memory 135 of the second reference level detection unit 130 in FIG. 1 and store the read reference level value in the first memory 125 of the first reference level detection unit 120.

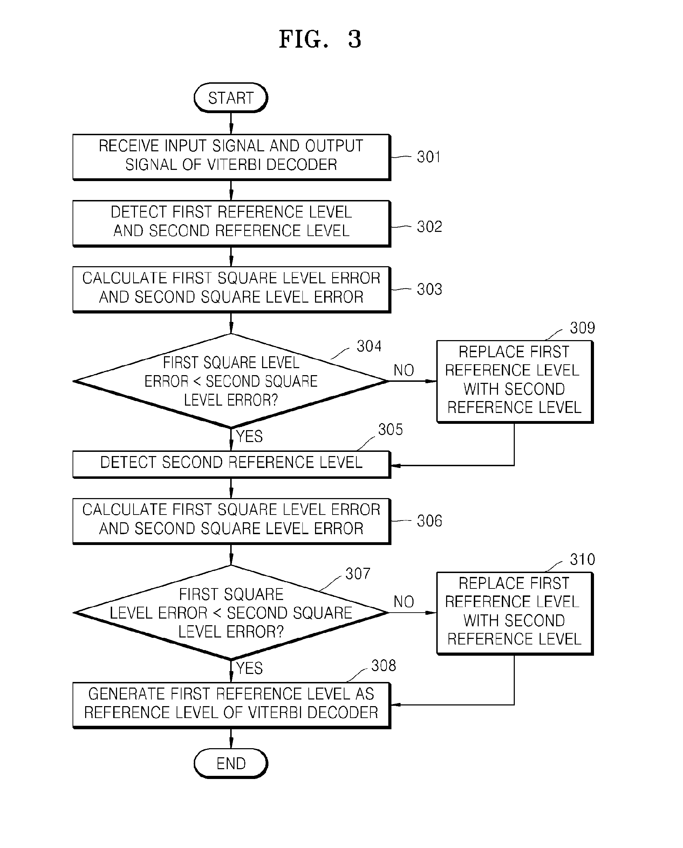

FIG. 3 is a flowchart illustrating a method of generating the reference level of the Viterbi decoder 110 according to an embodiment of the present invention. Referring to FIGS. 1 and 3, an input signal and an output signal of the Viterbi decoder 110 are received in operation 301. In operation 302, a delay signal for the received input signal, and the output signal are used to detect a first reference level of the Viterbi decoder 110 and the signal input after one clock cycle with respect to the delay signal, and the output signal are used to detect second reference level of the Viterbi decoder 110. The first reference level is detected in the same manner as in the first reference level detection unit 120 of FIG. 1. The second reference level is detected in the same manner as in the second reference level detection unit 130 of FIG. 1.

In operation 303, a first square level error for the first reference level and a second square level error for the second reference level are respectively calculated. That is, an ideal reference level value is detected from the plurality of reference level values as described in FIG. 1 and the detected reference level value and the input signal are calculated as in Equation 1 so as to obtain the first square level error and the second square level error.

As a result of the comparison between the first square level error and the second square level error, when the first square level error is smaller than the second square level error, in operation 304, the second reference level of the Viterbi decoder 110 is detected, in operation 305, using the signal input before one clock cycle with respect to the delay signal and the output signal used in the first reference level.

Then, in operation 306, the first square level error and the second square level error are calculated. After comparing the calculated first square level error and second square level error, when the first square level error is smaller than the second square level error, in operation 307, the first reference level is generated as the reference level of the Viterbi decoder 110, in operation 308.

As a result of the comparison between the first square level error and the second square level error, when the first square level error is larger than the second square level error, in operation 304, the first reference level is replaced with the second reference level, in operation 309. Then, operation 305 is executed so that the signal input before one clock cycle with respect to the delay signal and the output signal used for detecting the first reference level in operation 302 are used and the second reference level of the Viterbi decoder 110 is detected again.

Then, in operation 306, the first square level error and the second square level error are calculated. Here, the first square level error is calculated using the replacement second reference level obtained in operation 309.

When the first square level error is not smaller than the second square level error, in operation 307, the first reference level is replaced with the second reference level. Here, the second reference level is detected using the signal input before one clock cycle with respect to the delay signal used in the first reference level. That is, in the replacing in operation 310, the second reference level detected in operation 305 (the reference level detected using the signal input before one clock cycle with respect to the delay signal used in the first reference level detected in operation 302) has the smallest square level error from among the first reference level detected in operation 302, the second reference level detected in operation 302, and the second reference level detected in operation 305 and is determined as the optimum reference level adaptable for the input signal.

Accordingly, the reference level generated in operation 308 becomes the reference level detected using the signal input before one clock cycle with respect to the delay signal used in the first reference level. Thus, when the method as in FIG. 3 is executed, the optimum reference level adaptable for the input signal may be provided to the Viterbi decoder 110 and thus, the error generation rate in the binary signal output from the Viterbi decoder 110 may be reduced.

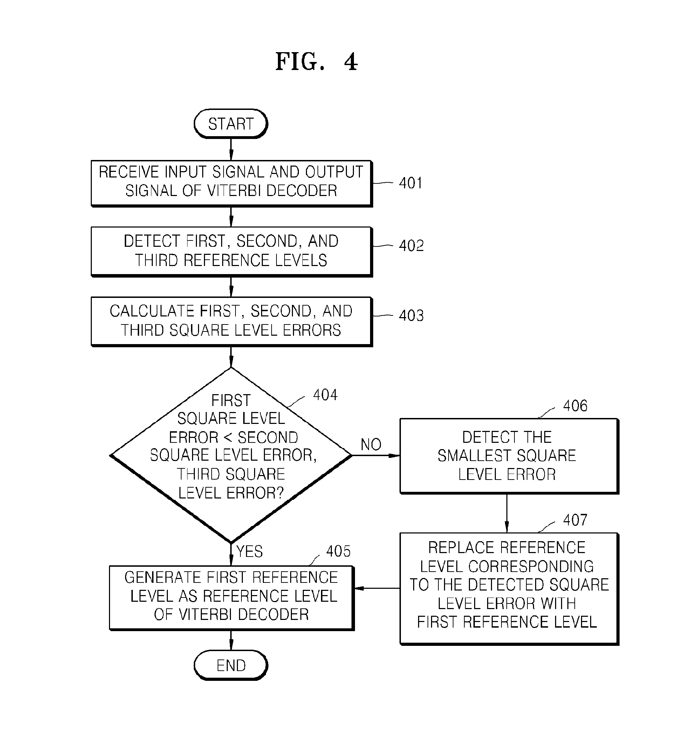

FIG. 4 is a flowchart illustrating a method of generating the reference level of the Viterbi decoder 210 of FIG. 2 according to another embodiment of the present invention. Unlike the embodiment shown in FIG. 3, the second reference level detected using the signal input after one clock cycle with respect to the delay signal used to detect the first reference level and the output signal of Viterbi decoder 110, described in FIG. 3, is detected simultaneously with the second reference level detected using the signal input before one clock cycle with respect to the delay signal used to detect the first reference level so that the optimum reference level for the input signal is generated in FIG. 4.

Thus, in operation 401, when an input signal and an output signal of the Viterbi decoder 210 are received, first, second, and third reference levels are detected in operation 402. Detecting of the first, second, and third reference levels may be performed in parallel, as in FIG. 2.

In operation 403, first, second, and third square level errors are calculated using the detected first, second, and third reference levels and the delayed input signals used in detecting the first, second, and third reference levels. As a result of the comparison between the calculated first, second, and third square level errors, if the first square level error is the smallest, in operation 404, the first reference level is generated as the reference level of the Viterbi decoder 210, in operation 405.

As a result of the comparison between the calculated first, second, and third square level errors, if the first square level error is not the smallest, the smaller one is detected from among the second square level error and the third square level error, in operation 406. Then, the reference level corresponding to the smaller square level error replaces the first reference level, in operation 407, and the first reference level is generated as the reference level of the Viterbi decoder 210, in operation 405.

As in the embodiment of FIG. 4, since the optimum reference level of the Viterbi decoder 210 is provided, the error generation rate in the binary signal output from the Viterbi decoder 210 may be reduced and rapid Viterbi decoding may be expected.

While not required in all aspects, all or portions of the invention can also be embodied as computer readable codes on a computer readable recording medium. The computer readable recording medium is any data storage device that can store data which can be thereafter read by a computer system. Examples of the computer readable recording medium include read-only memory (ROM), random-access memory (RAM), CD-ROMs, magnetic tapes, floppy disks, and optical data storage devices. In addition, the computer readable recording medium can also be distributed over network coupled computer systems so that the computer readable code is stored and executed in a distributed fashion.

Although a few preferred embodiments have been shown and described, it will be appreciated by those skilled in the art that various changes and modifications might be made without departing from the scope of the invention, as defined in the appended claims.

Attention is directed to all papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings) may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extends to any novel one, or any novel combination, of the features disclosed in this specification (including any accompanying claims, abstract and drawings), or to any novel one, or any novel combination, of the steps of any method or process so disclosed.

## Claims

1. An apparatus (115, 215) for generating a reference level of a Viterbi (110, 210) decoder, the Viterbi decoder (110, 210) receiving an input signal and outputting an output signal according to the reference level, the apparatus (115, 215) comprising:
a first reference level detection unit (120, 220) to detect a first reference level using a first delayed input signal and the output signal of the Viterbi decoder (110, 210), the delayed input signal being delayed relative to the input signal;
a second reference level detection unit (130, 230) to detect second reference levels using the output signal of the Viterbi decoder (110, 210) and a second delayed input signal and a third delayed input signal input one clock cycle after and before the first delayed input signal; and
a control unit (140, 240) to select one of the first reference level and the second reference level as the reference level of the Viterbi decoder (110, 210) using a result of a comparison between a first square level error for the first reference level calculated in the first reference level detection unit (130) and a second square level error for the second reference levels calculated in the second reference level detection unit (230).

2. The apparatus of claim 1, wherein:
the first reference level detection unit (120, 220) obtains the first square level error by squaring a difference between the first reference level and the input signal of the Viterbi decoder (110, 210), and
the second reference level detection unit (130, 230) obtains the second square level errors by squaring the differences between each of the second reference levels and the input signal of the Viterbi decoder (110, 210).

3. The apparatus of claim 1 or 2, wherein the control unit (140, 240) selects the reference level to be the one of the first and second reference levels having a smallest of the first and second square level errors.

4. The apparatus of claim 1, 2 or 3, wherein:
the second reference level detection unit (230) comprises:
a first reference level detector (231) to detect one of the second reference levels using the second delayed input signal input one clock cycle after the first delayed input signal; and
a second reference level detector (232) to detect the other one of the second reference levels using the third delayed input signal input one clock cycle before the first delayed input signal, and
the control unit (240) selects as the reference level the one of the first and second reference levels having the smallest of the first and the second square level errors respectively calculated in the first reference level detection unit (220) and the second reference level detection unit (230).

5. The apparatus of claim 4, wherein:
the first reference level detection unit (230), the first reference level detector (231), and the second reference level detector (232) respectively each comprise:
a delaying unit (121, 131, 233) to delay the input signal of the Viterbi decoder (210);
a buffer (122, 132, 234) to store the output signal of the Viterbi decoder (210) by a predetermined bit and to output the stored signal;
a multiplexer (123, 133, 235) to selectively transmit the delayed input signal output from the delaying unit (121, 131, 233) according to the output stored signal output from the buffer (122, 132, 234);
an average value detector group (124, 134, 236) comprising a plurality of average value detectors which detects an average value of the selectively transmitted signal through the multiplexer (123, 133, 235) and to output the detected value, the number of the average value detectors corresponding to a number of reference levels which can be generated;
a memory (125, 135, 237) to store at least one of the reference values output from the average value detector group (124, 134, 236); and
a square level error calculator (126, 136, 238) to calculate the square level error using the one of the reference levels stored in the memory (125, 135, 237) and the input signal of the Viterbi decoder (210), wherein
the delaying unit (121) included in the first reference level detector (231) is arranged to output a signal input one clock cycle after the input signal output from the delaying unit (121) included in the first reference level detection unit (220), and
the delaying unit (131) included in the second reference level detector (232) is arranged to output a signal input one clock cycle before the input signal output from the delaying unit (121) included in the first reference level detection unit (220).

6. The apparatus of claim 5, wherein one or more of square level error calculators (126, 136, 238) is arranged to output an ideal reference level from among the reference levels stored in the associated memory (125, 135, 237).

7. A method of generating a reference level of a Viterbi decoder, the Viterbi decoder receiving an input signal and outputting an output signal according to the reference level, the method comprising:
receiving the input signal and the output signal from the Viterbi decoder (301, 401);
detecting a first reference level of the Viterbi decoder using a first delayed input signal and the received output signal (302, 402);
detecting second reference levels using the output signal from the Viterbi decoder and a second delayed input signal and a third delayed input signal input one clock cycle after and before the first delayed input signal;
respectively calculating a first square level error for the first reference level and second square level errors for the second reference levels; and
selecting as the reference level for the Viterbi decoder according to a result of a comparison between the calculated first square level error and the second square level errors (304-310, 404-407).

8. The method of claim 7, wherein the calculating the first square level error comprises squaring a difference between the detected first reference level and the input signal of the Viterbi decoder, and
the calculating the second square level error comprises squaring corresponding differences between the second reference levels and the input signal of the Viterbi decoder.

9. The method of claim 7 or 8, wherein in the selecting as the reference level comprises selecting as the reference level the one of the first and second reference levels corresponding to a smallest one of the first and the second square level errors .

10. The method of claim 7, wherein:
the detecting of the second reference levels comprises:
detecting one of the second reference levels using the second delayed input signal input one clock cycle after the first delayed input signal; and
detecting the other one of the second reference levels using the third delayed input signal input one clock cycle before the first delayed input signal,
the second square level errors for the second reference levels comprise a square level error for the second delayed input signal and a square level error for the third delayed input signal (404-406), and
the selecting of the reference level of the Viterbi decoder comprises selecting as the reference level the one of the first and second reference levels corresponding to the smallest one of the first square level error and the second square level errors (407-405).

11. The method of claim 10, wherein the one of the reference levels used in calculating the square level errors is a current ideal reference level from among the detected reference levels.
